# FASCICULE DE BREVET EUROPEEN

(11) **EP 2 087 592 B1**
(45) Date de publication et mention de la délivrance du brevet: **20.01.2010**
(21) Numéro de dépôt: 07822087.8
(22) Date de dépôt: 31.10.2007
(51) Int. Cl.: H03K 19/003, H02H 11/00

(54) **ETAGE DE SORTIE LOGIQUE DE CIRCUIT INTEGRE PROTEGE CONTRE UNE INVERSION DE BATTERIE**
VOR BATTERIEVERPOLUNG GESCHÜTZTE LOGIKAUSGANGSSTUFE EINER INTEGRIERTEN SCHALTUNG
LOGIC OUTPUT STAGE OF INTEGRATED CIRCUIT PROTECTED AGAINST BATTERY INVERSION

(30) Priorité: 10.11.2006 FR 0609842
(43) Date de publication de la demande: 12.08.2009
(73) Titulaire: E2V Semiconductors, 38120 Saint Egreve (FR)
(72) Inventeur: MASSON, Thierry, 38760 Antony (FR); COQUILLE, Pierre, 38119 Saint Theoffrey (FR)
(74) Mandataire: Guérin, Michel
(86) Numéro de dépôt international: PCT/EP2007/061740
(87) Numéro de publication internationale: WO 2008/055830

(56) Documents cités:
- EP-A2- 0 360 991
- US-A- 4 423 456
- US-A1- 2002 089 803

## Description

L'invention concerne les circuits électroniques intégrés de technologie MOS qui doivent être alimentés par une pile ou une batterie pouvant avoir une tension relativement élevée susceptible de détruire le circuit en cas d'erreur de connexion de la batterie. L'erreur envisagée ici est notamment une connexion malencontreuse d'une tension négative sur une sortie du circuit intégré dont le substrat est à un potentiel plus positif (une référence de masse par exemple).

A titre d'exemple, dans les applications automobiles, la tension classique d'alimentation est fournie par une batterie de 12 volts qui est rechargée en permanence à travers un régulateur. En cas d'erreur de branchement de la batterie dans le véhicule (connexion de la borne négative sur une sortie de circuit intégré non destinée à recevoir cette connexion) on peut à la rigueur admettre que les diverses installations électroniques cessent de fonctionner mais on ne peut pas admettre qu'elles soient détruites. On veut non seulement qu'elles résistent à -12 volts mais même par sécurité jusqu'à -16 volts (typiquement).

Une borne de sortie logique comprend le plus souvent un étage de sortie push-pull comprenant un transistor PMOS et un transistor NMOS en série, la sortie de l'étage étant reliée au point de jonction des deux transistors. Par étage push-pull, on entend un montage de deux transistors en série entre les bornes d'alimentation, l'un des transistors étant rendu conducteur pendant que l'autre est bloqué et réciproquement, en fonction de l'état logique de l'entrée de l'étage.

Dans ce type d'étage, la sortie est donc connectée au drain du transistor MOS à canal N ; or ce drain est une région semiconductrice dopée de type N qui forme avec le substrat de type P (ou avec un caisson de type P au potentiel du substrat) une jonction NP.

Cette jonction devient polarisée en direct si une tension d'alimentation négative est appliquée par erreur sur la sortie, alors que le substrat est à une tension plus positive (zéro). La jonction claque et détruit le circuit intégré.

Les solutions existantes pour éviter ce risque consistent essentiellement à prévoir une diode en série avec la sortie logique, dans le sens inverse de la jonction mentionnée ci-dessus. Cette diode empêche le passage de courant inverse en cas de connexion malencontreuse de la borne négative de la batterie sur cette entrée. Mais cette diode n'est pas facile à intégrer dans le substrat du circuit intégré, et de plus elle introduit une chute de tension d'environ 0,7 volts dans la connexion de sortie en régime normal, ce qui est gênant lorsque la sortie doit être à un niveau logique bas. En outre, il faut polariser la diode dans le sens direct pour être sûr qu'elle n'introduit pas une chute de tension encore supérieure, d'où une consommation indésirable de courant.

On a aussi proposé d'utiliser non pas une diode en série mais une résistance en série. Les mêmes inconvénients subsistent : par exemple, avec un courant de sortie nominal de 10 mA et une résistance de limitation de courant d'au moins 50 ohms (pour éviter la destruction de la jonction en cas de mauvaise connexion), une chute de tension de 0,5 volts se produit en régime normal, dégradant le niveau logique bas que peut fournir la sortie du circuit intégré.

Pour résoudre ce problème, l'invention propose de modifier l'étage de sortie pour remplacer l'ensemble en série d'un transistor NMOS et d'un transistor PMOS par une ensemble en série de deux transistors PMOS, commandés par des niveaux logiques inversés, le transistor PMOS relié au potentiel le plus bas de l'alimentation ayant sa grille commandée par un circuit (une sorte de pompe de charge) fournissant une tension plus basse que le potentiel le plus bas lorsque le transistor doit être rendu conducteur.

En d'autres mots, l'invention proposée est un étage de sortie logique d'un circuit intégré de technologie CMOS, comportant une entrée pour un signal logique d'entrée, deux transistors en série fonctionnant en push-pull sous la commande du signal logique d'entrée, un premier transistor étant relié à une borne d'alimentation haute et le deuxième étant relié à une borne d'alimentation basse, et une sortie reliée au point de jonction des deux transistors, caractérisé en ce que les deux transistors sont des transistors PMOS, et en ce qu'un circuit de commande de conduction, apte à appliquer à la grille du deuxième transistor une tension négative par rapport à la borne d'alimentation basse lorsque le signal logique d'entrée passe à un niveau tendant à bloquer le premier transistor, est interposé entre l'entrée et la grille du deuxième transistor.

De préférence, le circuit de commande de conduction comporte un troisième et un quatrième transistors PMOS en série, le troisième transistor étant relié à la borne d'alimentation haute et le quatrième à la borne d'alimentation basse, et le point de jonction des troisième et quatrième transistors étant relié à la grille du deuxième transistor, la grille du quatrième transistor étant commandée par un signal logique inverse du signal d'entrée, le circuit comportant encore une capacité dont une première borne est reliée au point de jonction des troisième et quatrième transistors et une deuxième borne reçoit un signal correspondant au signal de commande du quatrième transistor retardé par un élément de retard.

On prévoit de préférence qu'un cinquième transistor PMOS est placé en parallèle avec le deuxième, la grille du cinquième transistor étant commandée par un deuxième circuit de commande de conduction identique au premier, les deux circuits étant actionnés en alternance sous la commande d'une horloge qui autorise le fonctionnement de l'un pendant qu'elle interdit le fonctionnement de l'autre et réciproquement.

Le deuxième et le cinquième transistors sont avantageusement placés dans un même caisson de type opposé au substrat du circuit intégré.

Dans un perfectionnement, le deuxième transistor est placé dans un caisson de type N dont le potentiel est fixé, par un circuit de polarisation de caisson, à la valeur du potentiel de la sortie si ce potentiel est positif par rapport au substrat et à une valeur de potentiel proche de celle du substrat si un potentiel négatif par rapport au substrat est appliqué à la sortie.

L'étage de sortie selon l'invention est particulièrement avantageux lorsque la sortie est directement reliée à une borne de connexion extérieure du circuit intégré.

D'autres caractéristiques et avantages de l'invention apparaîtront à la lecture de la description détaillée qui suit et qui est faite en référence aux dessins annexés dans lesquels :
- la figure 1 représente le principe de départ d'un étage de sortie selon la présente invention ;
- la figure 2 représente l'étage de sortie avec son circuit de commande de conduction ;
- la figure 3 représente l'étage de sortie avec le détail du circuit de commande de conduction ;
- la figure 4 représente le chronogramme des signaux du circuit de la figure 3 ;
- la figure 5 illustre le chronogramme dans le cas où l'entrée reste longtemps au niveau haut ;
- la figure 6 représente une modification de l'étage de sortie pour permettre à l'entrée de rester longtemps au niveau haut ;
- la figure 7 représente un chronogramme du circuit de la figure 6 ;
- la figure 8 représente un circuit de polarisation du caisson du deuxième transistor de l'ensemble push-pull relié à la sortie.

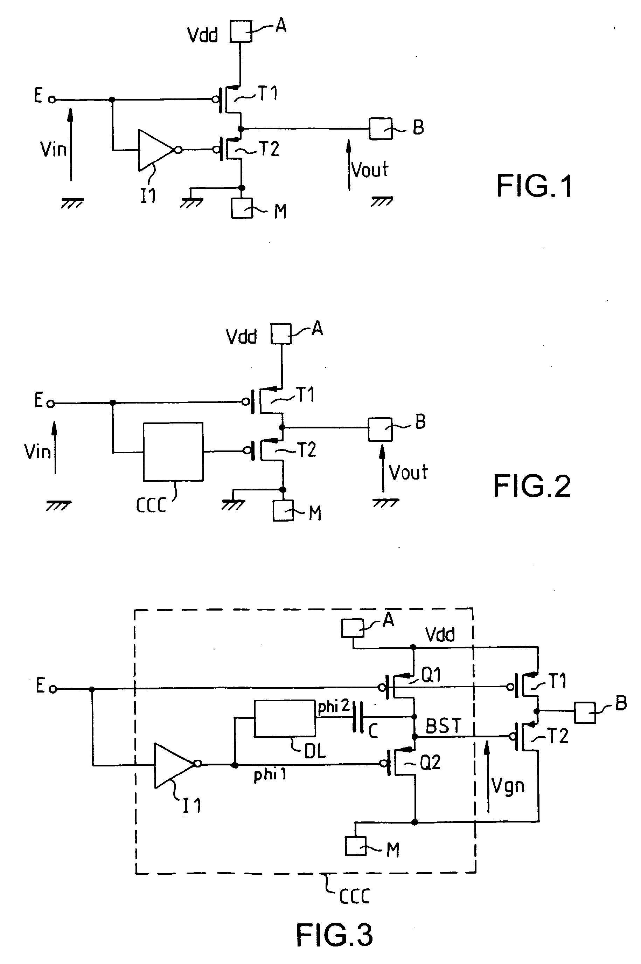

Sur la figure 1, on a représenté sous forme simplifiée le principe de base d'un étage de sortie logique selon l'invention.

Le circuit intégré lui-même, avec ses différentes fonctionnalités, n'est pas représenté et on suppose qu'il doit fournir sur une borne de sortie extérieure B un signal logique Vout de niveau haut ou bas selon le niveau logique Vin bas ou haut que cet étage reçoit sur une entrée E.

L'étage de sortie comporte deux transistors PMOS T1 et T2 en série entre les bornes d'alimentation haute et basse, A et M, du circuit intégré. Ces bornes sont destinées à recevoir respectivement un potentiel de référence nul (borne M) et un potentiel d'alimentation positif Vdd (borne A), par exemple de 12 volts dans une application automobile. Les transistors sont montés en push-pull logique, en ce sens que l'un des deux est commandé pour être conducteur pendant que l'autre est commandé pour être bloqué et réciproquement. La source du transistor T1 est au potentiel d'alimentation haut Vdd ; le drain de T1 et la source de T2 sont reliés ensemble à la borne de sortie B pour fournir un signal de sortie Vout ; le drain de T2 est relié au potentiel d'alimentation bas (masse M).

L'entrée E de l'étage est reliée directement à la grille du transistor T1, et reliée par l'intermédiaire d'un inverseur I1 à la grille du transistor T2.

Lorsque le signal d'entrée Vin est au niveau bas (potentiel de M), le transistor T1 est conducteur et le transistor T2 est bloqué ; la sortie fournit un niveau logique Vout haut (au potentiel Vdd de A). Inversement, si le signal d'entrée Vin est au niveau haut, c'est le transistor T2 qui est conducteur et le transistor T1 est bloqué ; la sortie fournit un niveau logique Vout bas (potentiel de M).

Toutefois, le niveau logique bas ainsi obtenu n'est pas un bon niveau bas. En portant la grille du transistor T2 à la masse M, il n'est guère possible de faire descendre la tension de sortie Vout au-dessous d'environ 1 volt, à cause de la tension de seuil qu'il faut nécessairement appliquer entre grille et source pour rendre le transistor T2 conducteur. Or le bon fonctionnement des circuits raccordés en aval de la borne de sortie B peut nécessiter que le niveau logique bas fourni sur cette borne soit vraiment un niveau bas (très proche de zéro) et non pas un niveau de 1 ou 1,5 volts.

C'est pourquoi, on prévoit que le transistor au potentiel le plus bas (T2) a sa grille commandée par un circuit capable de descendre le potentiel de grille au-dessous du potentiel de la borne d'alimentation la plus basse lorsque ce transistor doit être rendu conducteur.

Le circuit de la figure 2 représente schématiquement ce principe. On a remplacé le simple inverseur de la figure 1 par un circuit de commande de conduction CCC qui a les fonctionnalités suivantes :
- à la réception d'un signal logique de niveau bas sur l'entrée E, il bloque le transistor T2 en appliquant sur sa grille une tension égale à la tension d'alimentation Vdd ;
- à la réception d'un signal de niveau haut sur l'entrée E, il rend le transistor T2 franchement conducteur en appliquant sur sa grille une tension plus négative que le potentiel de la borne d'alimentation basse M.

La figure 3 représente un exemple de circuit de commande de conduction CCC remplissant ces fonctionnalités. Ce circuit comprend:
- un montage push-pull de deux transistors PMOS Q1 et Q2, montés en série comme les transistors T1 et T2 entre les bornes d'alimentation A et M (source de Q1 à Vdd et drain de Q2 à la masse M) ; la grille du transistor Q1 est commandée directement par l'entrée E ; la grille du transistor Q2 est commandée par un inverseur I1 dont l'entrée est reliée à l'entrée E ;
- un circuit de retard DL pour retarder le front de descente qui se présente à la sortie de l'inverseur,
- une capacité C connectée entre la sortie du circuit de retard et la sortie BST du circuit de commande de conduction CCC ; cette sortie du circuit de commande est la sortie de l'étage push-pull Q1, Q2, prise sur le drain de Q1 relié à la source de Q2.

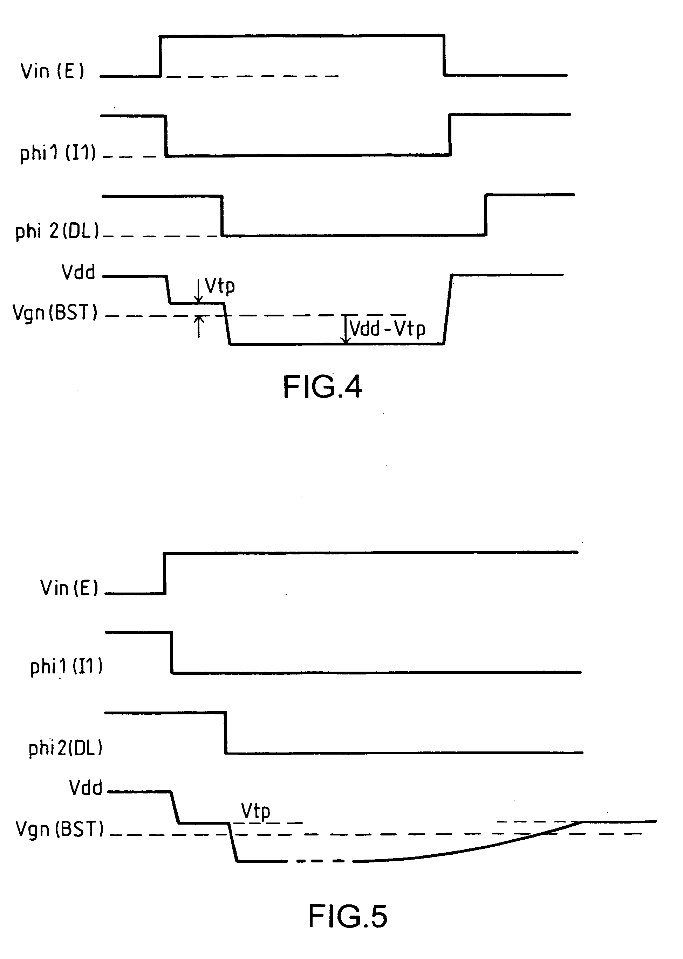

Ce circuit de commande de conduction CCC, qui peut être appelé circuit de "pompe de charge", fonctionne de la manière suivante, expliquée en référence au chronogramme de signaux de la figure 4 :

Lorsque l'entrée E est au niveau bas, le transistor T1 est conducteur et le transistor T2 est bloqué par l'état haut du signal phi1 de sortie de l'inverseur I1. La sortie BST est au niveau haut Vdd.

Lors d'un front logique montant du niveau bas vers le niveau haut sur l'entrée E (première ligne du chronogramme), le transistor Q1 se bloque ; le signal phi1 descend à zéro (deuxième ligne du chronogramme) ; ce signal phi1, appliqué à la grille du transistor Q2, tend à le rendre conducteur ; le potentiel Vgn sur la sortie BST du circuit descend jusqu'à une valeur Vtp proche de la tension de seuil du transistor T2 (voir quatrième ligne du chronogramme) ; ce potentiel ne peut pas descendre plus bas sous le seul effet de la sortie de l'inverseur I1.

A partir du signal phi1, on produit un signal phi2, identique à phi1 mais retardé par le circuit à retard DL (troisième ligne du chronogramme) ; ce signal phi2 est appliqué à la capacité C ; le passage brutal de phi2 au niveau bas fait baisser brusquement le potentiel de la sortie BST, par simple effet capacitif ; le potentiel de la sortie BST devient sensiblement égal à Vtp-Vdd si on fait l'hypothèse que l'amplitude du signal phi2 est sensiblement égale à Vdd, ce qui est facile à obtenir dans un circuit logique.

Vdd est largement supérieur à Vtp, de sorte que le niveau de potentiel sur la sortie BST devient franchement négatif lors du front descendant de phi2 ; le potentiel de source de Q2 devient plus négatif que le potentiel de grille ; le transistor Q2 se bloque complètement, le transistor Q1 étant déjà bloqué. Le noeud BST reste isolé et conserve son potentiel négatif.

C'est cette sortie BST qui sert à commander la grille du transistor T2 de l'étage de sortie. Lors d'un front montant sur l'entrée E on produit ainsi une tension négative Vtp-Vdd qui rend franchement conducteur le transistor T2 par une polarisation de grille plus négative que la source.

Lors d'un front logique redescendant du niveau haut vers le niveau bas sur l'entrée E, le transistor Q1 est rendu conducteur, le transistor Q2 est bloqué, la sortie BST passe à Vdd ; lorsque phi2 remonte à Vdd, la capacité C se décharge. On pourrait envisager que le circuit de retard DL n'agisse en circuit de retard que pour des fronts de descente en sortie de l'inverseur I1, mais il est plus simple d'utiliser comme circuit à retard une paire d'inverseurs ou plus généralement un nombre pair d'inverseurs et dans ce cas il agit aussi bien sur les fronts de montée que les fronts de descente.

Ce circuit est bien adapté à un fonctionnement dans lequel le signal logique sur l'entrée E varie dynamiquement. Il a un défaut lorsque le signal sur l'entrée E doit pouvoir garder statiquement un niveau haut pendant assez longtemps. En effet, les fuites du transistor Q1 risquent de faire remonter progressivement le niveau du potentiel Vgn de la sortie BST, comme cela est visible sur la figure 5.

La figure 5 représente le chronogramme des signaux dans cette hypothèse où le signal d'entrée reste statiquement au niveau haut pendant un temps suffisant pour que le potentiel de sortie Vgn commence à évoluer. On voit ce potentiel remonter vers le niveau zéro puis le dépasser jusqu'à se stabiliser aux alentours de Vtp. Il ne monte pas au delà de Vtp car lorsqu'il atteint Vtp le transistor T2 qui a sa grille à la masse devient conducteur et maintient la sortie proche de Vtp.

Lorsqu'il est à Vtp, ou même à une valeur inférieure, il est clair que le circuit de commande de conduction ne remplit plus sa fonction car la tension sur la borne de sortie B sera proche de 2Vtp au lieu d'être franchement nulle (on suppose que les transistors Q1 et T1 ont la même tension de seuil Vtp).

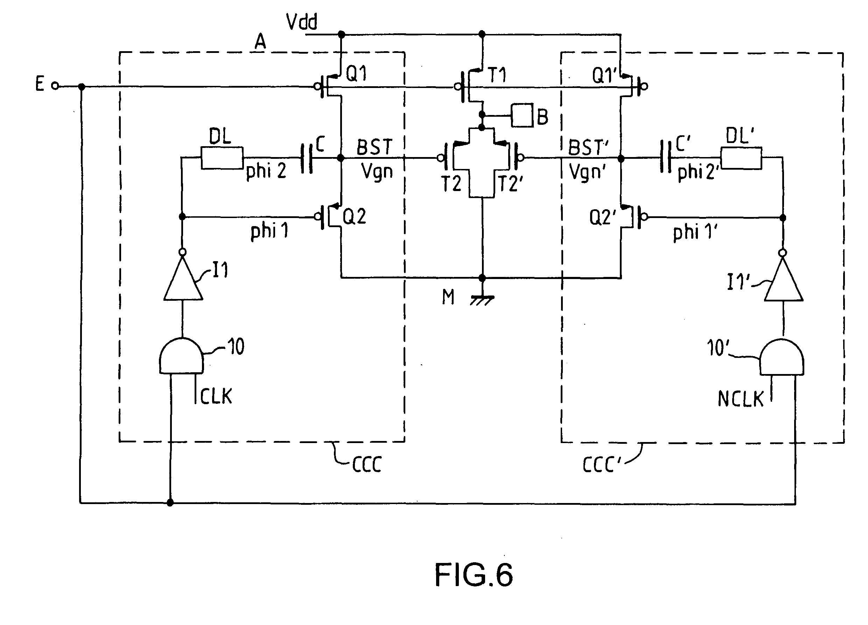

On propose selon l'invention un perfectionnement qui est représenté à la figure 6. Ce perfectionnement consiste à prévoir une deuxième transistor T'2 en parallèle sur le transistor T2, avec un circuit de commande de conduction CCC' pour le transistor T2', identique au circuit CCC mais commandé en alternance avec lui sous la commande d'une horloge : pendant un créneau d'horloge CLK c'est le circuit CCC qui agit sur le transistor T2 ; pendant le créneau complémentaire suivant NCLK, c'est le circuit CCC' qui agit sur le transistor T2'. Les fronts de l'horloge sont utilisés pour faire baisser capacitivement le potentiel de sortie Vgn ou Vgn' des deux circuits CCC et CCC'.

Ainsi, alternativement, à la cadence de l'horloge, le transistor T2 puis le transistor T2' seront rendus franchement conducteurs, de sorte que même si le potentiel Vgn tend à remonter à la sortie du circuit CCC, il n'aura pas le temps de le faire avant que le potentiel Vgn' de sortie du circuit CCC' ne subisse une nouvelle impulsion qui lui confère une valeur négative.

Les fronts descendants de sortie de l'élément retard DL peuvent être déclenchés par les fronts montant et descendant de l'horloge.

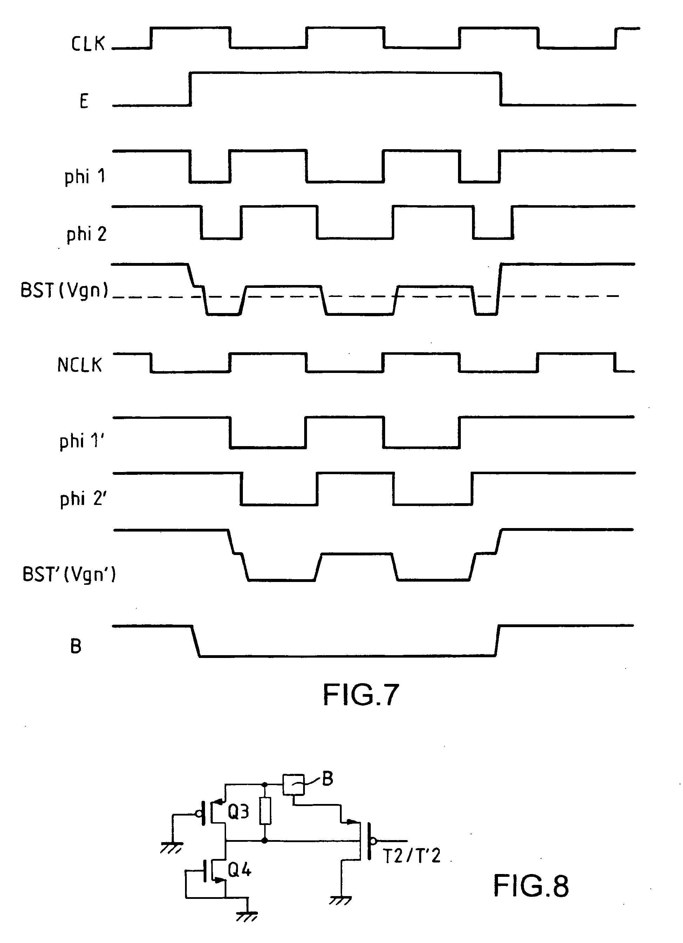

La figure 6 représente un exemple de réalisation du circuit et la figure 7 représente le chronogramme de signaux associés.

L'entrée E reste reliée directement à la grille du transistor T1, et elle est également reliée directement aux grilles des transistors Q1 et Q'1 des circuits identiques CCC et CCC'. Les circuits CCC et CCC' sont modifiés par rapport à la figure 3 en ce qu'ils comportent chacun une porte logique ET, respectivement désignées par 10 et 10', dont une entrée est reliée à l'entrée E et dont l'autre entrée reçoit le signal d'horloge CLK pour la porte 10 et le complément NCLK du signal d'horloge pour la porte 10'. Les circuits CCC et CCC' fonctionnent alternativement à chaque créneau d'horloge lorsque le niveau d'entrée E est haut. Ils sont inertes par rapport à l'horloge, c'est-à-dire qu'ils jouent simplement le rôle d'inversion du signal d'entrée E, lorsque le niveau d'entrée est bas.

Lorsque le niveau d'entrée est haut, le signal phi1 reproduit, en l'inversant, le signal d'horloge CLK ; le signal phi1' reproduit, en l'inversant, le complément NCLK du signal CLK. Les signaux phi2 et phi2' sont identiques à phi1, phi1', mais retardés par les éléments de retard DL, DL'. La tension de sortie Vgn sur la sortie BST du circuit CCC chute de Vdd à environ Vtp lors du front descendant de phi1, puis de Vtp à Vtp-Vdd lors du front descendant de phi2. Le transistor T2 devient franchement conducteur et maintient à zéro la sortie B. Lorsque phi2 remonte à 1, la tension de sortie Vgn remonte à Vtp et ne rend plus le transistor T2 suffisamment conducteur, mais au même moment le signal phi2' passe à Vtp-Vdd et rend franchement conducteur le transistor T2'. La sortie B reste donc à zéro. Les transistors T2 et T2' sont conducteurs en alternance et maintiennent à zéro la sortie B jusqu'à ce que l'entrée E repasse au niveau bas.

Si l'entrée E repasse au niveau bas pendant un niveau haut de l'horloge CLK, elle fait passer phi1 à 1 (blocage de Q2) en même temps qu'elle rend conducteur Q1. La sortie BST qui était à Vtp-Vdd passe de ce fait à Vdd et bloque T2 en même temps que l'entrée E passe au niveau bas. A ce moment là, la sortie BST' étant au niveau Vtp et passe à Vdd, bloquant aussi le transistor T2'. L'inverse se produit, avec le même résultat, si l'entrée repasse à 1 pendant le niveau bas de l'horloge CLK.

Les transistors T2 et T2' sont dans un même caisson N formé dans le substrat du circuit. Le transistor T1 est dans un caisson séparé.

Pour améliorer l'efficacité de la polarisation négative de grille du transistor T2 (ou des transistors T2 et T2'), on prévoit de préférence de porter le caisson du transistor T2 (ou T2 et T2') au potentiel de la source de T2, donc à la sortie B. Cela permet d'éviter que la tension de seuil Vtp de ce transistor soit dépendante du niveau de sortie Vout sur la borne B. En effet, la tension de seuil tend à s'accroître lorsque le niveau de sortie descend même en présence d'une tension de grille négative. En maintenant le caisson au potentiel de sortie, on évite cet inconvénient. Toutefois, on ne peut pas relier directement le caisson à la source en établissant une liaison entre la source (de type P) et une diffusion de type N formée dans le caisson. Si on faisait une telle liaison directe on établirait un chemin avec une seule diode substrat/caisson entre la sortie et le substrat, et cette diode passerait en direct en cas de branchement malencontreux de la borne négative de la batterie sur la sortie, et c'est justement ce qu'on voulait éviter. C'est pourquoi, on porte le caisson au potentiel de la sortie B par l'intermédiaire d'un circuit de polarisation de caisson qui polarise ce dernier
- au potentiel de la sortie B si celui-ci est positif (situation normale)
- à un potentiel proche du substrat s'il est négatif (situation accidentelle).

Le circuit de polarisation de caisson du transistor T2 est représenté à la figure 8. Il comprend un transistor PMOS Q3 formé dans un caisson de type N séparé des autres caissons. Ce transistor a son drain relié à son caisson ; il a sa source reliée à la sortie B ; il a sa grille reliée au substrat. Il comprend aussi un transistor NMOS Q4 monté en diode, dont le drain est relié au drain du transistor Q3, la source et la grille sont au substrat. Enfin, une résistance de limitation de courant, par exemple 100kohms, est reliée entre la sortie B et les drains de ces deux transistors. Les drains des transistors Q3 et Q4 forment la sortie du circuit de polarisation et ils sont reliés au caisson du transistor T2.

Si la tension sur la sortie B évolue entre 0 (potentiel de masse auquel est relié le substrat du circuit intégré) et une valeur positive, le transistor Q3 est conducteur et porte le caisson du transistor T2 à Vout. Le transistor Q4 est bloqué. Si la tension sur la sortie B devient malencontreusement négative par rapport au substrat (à la masse), le transistor Q3 se bloque, le transistor Q4 devient conducteur (son courant fortement limité par la résistance) et il porte le caisson du transistor T2 à un potentiel légèrement négatif.

Le caisson du transistor T1 reste quand à lui au potentiel Vdd auquel est porté sa source.

## Revendications

1. Etage de sortie logique d'un circuit intégré de technologie CMOS, comportant une entrée (E) pour un signal logique d'entrée, deux transistors (T1, T2) en série fonctionnant en push-pull sous la commande du signal logique d'entrée, un premier transistor (T1) étant relié à une borne d'alimentation haute (A) du circuit intégré et le deuxième (T2) à une borne d'alimentation basse (M), et une sortie (B) reliée au point de jonction des deux transistors, **caractérisé en ce que** les deux transistors sont des transistors PMOS, et **en ce qu'**un circuit de commande de conduction (CCC), apte à appliquer à la grille du deuxième transistor (T2) une tension négative par rapport à la borne d'alimentation basse lorsque le signal logique d'entrée passe à un niveau tendant à bloquer le premier transistor, est interposé entre l'entrée et la grille du deuxième transistor.

2. Etage de sortie selon la revendication 1, **caractérisé en ce que** le circuit de commande de conduction comporte un troisième et un quatrième transistors PMOS en série, le troisième transistor (Q1) étant relié à la borne d'alimentation haute et le quatrième (Q2) à la borne d'alimentation basse, et le point de jonction des troisième et quatrième transistors étant relié à la grille du deuxième transistor (T2), la grille du quatrième transistor étant commandée par un signal logique (phi1) inverse du signal d'entrée, le circuit comportant encore une capacité (C) dont une première borne est reliée au point de jonction des troisième et quatrième transistors et une deuxième borne reçoit un signal (phi2) correspondant au signal de commande du quatrième transistor retardé par un élément de retard (DL).

3. Etage de sortie selon l'une des revendication 1 et 2, **caractérisé en ce qu'**un cinquième transistor PMOS (T2') est placé en parallèle avec le deuxième (T2), la grille du cinquième transistor étant commandée par un deuxième circuit de commande de conduction (CCC') identique au premier (CCC), les deux circuits étant actionnés en alternance sous la commande d'une horloge qui autorise le fonctionnement de l'un pendant qu'elle interdit le fonctionnement de l'autre et réciproquement.

4. Etage de sortie selon la revendication 3, **caractérisé en ce que** le deuxième et le cinquième transistors (T2, T2') sont placés dans un même caisson de type opposé au substrat du circuit intégré.

5. Etage de sortie selon l'une des revendications 1 à 4, **caractérisé en ce que** le deuxième transistor (T2) est placé dans un caisson de type N dont le potentiel est fixé à la valeur du potentiel de la source de ce transistor si ce potentiel est positif par rapport au substrat et à une valeur de potentiel proche de celle du substrat si un potentiel négatif par rapport au substrat est appliqué à la sortie (B).

6. Etage de sortie selon la revendication 5, **caractérisé en ce qu'**il comporte un circuit (Q3, Q4) de polarisation du caisson du deuxième transistor, comportant un transistor PMOS (Q3) ayant sa source reliée à la sortie (B), sa grille au substrat, et son drain relié au caisson ainsi qu'au drain d'un transistor NMOS (Q4) ayant sa source et sa grille reliées au substrat, les drains réunis de ces deux transistors étant reliés au caisson du deuxième transistor.

7. Etage de sortie selon l'une des revendications précédentes, **caractérisé en ce que** la sortie (B) est une borne de connexion extérieure du circuit intégré.

## Claims

1. Logic output stage of an integrated circuit in CMOS technology, comprising an input (E) for a logic input signal, two transistors (T1, T2) in series operating in push-pull mode under the control of the logic input signal, a first transistor (T1) being connected to a high supply terminal (A) of the integrated circuit and the second transistor (T2) to a low supply terminal (G), and an output (B) connected to the junction point of the two transistors, **characterized in that** the two transistors are pMOS transistors and **in that** a conduction control circuit (CCC), capable of applying a negative voltage with respect to the low supply terminal to the gate of the second transistor (T2) when the logic input signal goes to a level tending to turn off the first transistor, is interposed between the input and the gate of the second transistor.

2. Output stage according to Claim 1, **characterized in that** the conduction control circuit comprises third and fourth pMOS transistors in series, the third transistor (Q1) being connected to the high supply terminal and the fourth transistor (Q2) to the low supply terminal, and the junction point of the third and fourth transistors being connected to the gate of the second transistor (T2), the gate of the fourth transistor being controlled by a logic signal (phi1) the inverse of the input signal, the circuit further including a capacitor (C) a first terminal of which is connected to the junction point of the third and fourth transistors and a second terminal receives a signal (phi2) corresponding to the control signal for the fourth transistor, which signal is delayed by a delay component (DL).

3. Output stage according to either of Claims 1 and 2, **characterized in that** a fifth pMOS transistor (T2') is placed in parallel with the second transistor (T2), the gate of the fifth transistor being controlled by a second conduction control circuit (CCC') identical to the first (CCC), the two circuits being actuated alternately under the control of a clock that permits the operation of one of them while it prevents the operation of the other, and vice versa.

4. Output stage according to Claim 3, **characterized in that** the second and fifth transistors (T2, T2') are placed in one and the same well of opposite type to the substrate of the integrated circuit.

5. Output stage according to one of Claims 1 to 4, **characterized in that** the second transistor (T2) is placed in an n-type well, the potential of which is fixed to the value of the potential of the source of this transistor if this potential is positive relative to the substrate and to a potential value close to that of the substrate if a negative potential relative to the substrate is applied to the output (B).

6. Output stage according to Claim 5, **characterized in that** it includes a circuit (Q3, Q4) for biasing the well of the second transistor, said circuit comprising a pMOS transistor (Q3) having its source connected to the output (B), its gate connected to the substrate, and its drain connected to the well and to the drain of an nMOS transistor (Q4) having its source and its gate both connected to the substrate, the joined drains of these two transistors being connected to the well of the second transistor.

7. Output stage according to one of the preceding claims, **characterized in that** the output (B) is an external connection terminal of the integrated circuit .

## Patentansprüche

1. Logik-Ausgangsstufe einer integrierten Schaltung der CMOS-Technologie, mit einem Eingang (E) für ein logisches Eingangssignal, mit zwei in Reihe geschalteten Transistoren (T1, T2), die unter der Steuerung des logischen Eingangssignals im Gegentaktbetrieb arbeiten, wobei ein erster Transistor (T1) mit einer oberen Versorgungsklemme (A) der integrierten Schaltung und der zweite (T2) mit einer unteren Versorgungsklemme (M) verbunden ist, und mit einem Ausgang (B), der mit dem Verbindungspunkt der zwei Transistoren verbunden ist, **dadurch gekennzeichnet, dass** die zwei Transistoren PMOS-Transistoren sind, und dass eine Leitungssteuerschaltung (CCC), die an das Gate des zweiten Transistors (T2) eine negative Spannung bezüglich der unteren Versorgungsklemme anlegen kann, wenn das logische Eingangsignal auf einen Pegel übergeht, der die Tendenz hat, den ersten Transistor zu sperren, zwischen den Eingang und das Gate des zweiten Transistor eingefügt ist.

2. Ausgangsstufe nach Anspruch 1, **dadurch gekennzeichnet, dass** die Leitungssteuerschaltung einen dritten und einen vierten in Reihe geschalteten PMOS-Transistor aufweist, wobei der dritte Transistor (Q1) mit der oberen Versorgungsklemme und der vierte (Q2) mit der unteren Versorgungsklemme verbunden ist, und der Verbindungspunkt des dritten und des vierten Transistors mit dem Gate des zweiten Transistors (T2) verbunden ist, wobei das Gate des vierten Transistors von einem logischen Signal (phi1) invers zum Eingangssignal gesteuert wird, wobei die Schaltung noch einen Kondensator (C) aufweist, von dem eine erste Klemme mit dem Verbindungspunkt des dritten und vierten Transistors verbunden ist und eine zweite Klemme ein Signal (phi2) empfängt, das dem Steuersignal des vierten Transistors verzögert durch ein Verzögerungselement (DL) entspricht.

3. Ausgangsstufe nach einem der Ansprüche 1 und 2, **dadurch gekennzeichnet, dass** ein fünfter PMOS-Transistor (T2') parallel zum zweiten (T2) angeordnet ist, wobei das Gate des fünften Transistors von einer zweiten Leitungssteuerschaltung (CCC') gleich der ersten (CCC) gesteuert wird, wobei die zwei Schaltungen abwechselnd unter der Steuerung eines Taktgebers betätigt werden, der den Betrieb der einen erlaubt, während er den Betrieb der anderen verbietet und umgekehrt.

4. Ausgangsstufe nach Anspruch 3, **dadurch gekennzeichnet, dass** der zweite und der fünfte Transistor (T2, T2') in der gleichen Senke von dem Substrat der integrierten Schaltung entgegengesetztem Typ angeordnet sind.

5. Ausgangsstufe nach einem der Ansprüche 1 bis 4, **dadurch gekennzeichnet, dass** der zweite Transistor (T2) in einer Senke vom Typ N angeordnet ist, deren Potential auf den Wert des Potentials der Source dieses Transistors, wenn dieses Potential bezüglich des Substrats positiv ist, und auf einen Potentialwert nahe demjenigen des Substrats festgelegt wird, wenn ein negatives Potential bezüglich des Substrats an den Ausgang (B) angelegt wird.

6. Ausgangsstufe nach Anspruch 5, **dadurch gekennzeichnet, dass** sie eine Schaltung (Q3, Q4) zur Polarisierung der Senke des zweiten Transistors aufweist, die einen PMOS-Transistor (Q3) aufweist, dessen Source mit dem Ausgang (B), dessen Gate mit dem Substrat, und dessen Drain mit der Senke sowie mit dem Drain eines NMOS-Transistor (Q4) verbunden ist, dessen Source und Gate mit dem Substrat verbunden sind, wobei die vereinten Drains dieser zwei Transistoren mit der Senke des zweiten Transistors verbunden sind.

7. Ausgangsstufe nach einem der vorhergehenden Ansprüche, **dadurch gekennzeichnet, dass** der Ausgang (B) eine äußere Anschlussklemme der integrierten Schaltung ist.
